# EUROPEAN PATENT APPLICATION

(11) **EP 4 549 413 A1**
(43) Date of publication of application: **07.05.2025**
(21) Application number: 24205702.4
(22) Date of filing: 09.10.2024
(51) Int. Cl.: C04B 35/45, C04B 35/453, C04B 35/46, C04B 35/462, C04B 35/475, C04B 35/495, C04B 35/626, C04B 37/04, C30B 21/06, H01M 14/00

(54) **EUTECTIC FOR USE AS ACTIVE LAYER IN ELECTRODE FOR PHOTOELECTROCHEMICAL CELLS (PEC) AND ELECTRODE CONTAINING IT**

(30) Priority: 09.10.2023 PL 44632923
(71) Applicant: Ensemble3 spolka z ograniczona odpowiedzialnoscia, 01-919 Warszawa (PL)
(72) Inventor: SAHA, Sanjit, 01-946 Warszawa (PL); KOLODZIEJAK, Katarzyna, 02-776 Warszawa (PL); TOMCZYK, Monika, 03-147 Warszawa (PL); CUERVA, Miguel, 27-400 Monforte de Lemos (ES); TYMICKI, Emil, 01-922 Warszawa (PL); PAWLAK, Dorota Anna, 01-885 Warszawa (PL); SAR, Jaroslaw, 95-020 Andrespol (PL)
(74) Representative: JD&P Patent Attorneys Joanna Dargiewicz & Partners

(57) **Abstract**

The subject of the invention is a eutectic for use as an active layer in an electrode for photoelectrochemical cells (PEC), characterised in that it is a eutectic composite based on oxides selected from the group of TiO₂, NiO, NiTiO₃, Bi₂O₃, Bi₂CuO₄, V₂O₅, B₁₂TiO₂₀, BiVO₄. Another subject of the invention is an electrode for photoelectrochemical cells (PEC) comprising at least an active layer and an electrical contact and optionally a contact layer placed between the active layer and the electrical contact or current collector, characterised in that the active layer is a eutectic according to the invention.

## Description

The object of the invention is an eutectic for use as an active layer in an electrode for photoelectrochemical cells (PEC) and the electrode containing it.

In a photoelectrochemical cell (PEC), the semiconductor material absorbs sunlight and an electron-hole pair is formed. On the photoanode, for example, during the photolysis of water, the oxidation of O²⁻ ions to an oxygen atom (OER reaction) takes place, while on the photocathode the reduction of hydrogen ions H⁺ (HER reaction).

Nowadays, in a time of energy and environmental crisis, hydrogen is considered an excellent alternative to fossil fuels due to its high gravimetric energy, density, durability and environmentally friendly properties (Darbandi, M. et al. TiO2 nanoparticles with superior hydrogen evolution and pollutant degradation performance. Int J Hydrogen Energy 2019; 44, 24162-24173).

Current methods of hydrogen production are relatively expensive and insufficiently efficient. Among many techniques, water electrolysis coupled with photocatalysis seems to be the most promising (Huang LB, Zhao L, Zhang, Chen YYY, Zhang QH, Luo H, Zhang X, Tang T, Gu L, Hu JS. Fine Tuning Electronic Structure of Catalysts through Atomic Engineering for Enhanced Hydrogen Evolution, Adv Energy Mater 2018, 8, 1800789*;* Lin F. Dong Z, Yao Y, Lei Yang, Fang F, Jiao L. Electrocatalytic Hydrogen Evolution of Ultrathin Co-Mo5N6 Heterojunction with Interfacial Electron Redistribution, Adv Energy Mater 2020, 10, 2002176), as the process can be carried out at ambient temperature and pressure while not polluting the environment.

However, the catalytic process requires additional initiating energy. This can be in the form of electricity and it is electrocatalytic water splitting *(*Li R. et al. New TiO2-Based Oxide for Catalyzing Alkaline Hydrogen Evolution Reaction with Noble Metal-Like Performance. Small Methods 2021, 5*)* or in the form of photon energy, in which case the process is called photoelectrochemical water splitting.

Electrodes used for water electrolysis in the photolysis process (especially photoanodes) must meet several important requirements (Darbandi, M. et al. TiO2 nanoparticles with superior hydrogen evolution and pollutant degradation performance. Int J Hydrogen Energy 2019; 44, 24162-24173*;* H. Duan, D. Li, Y. Tang, Y. He, S. Ji, R. Wang, H. Lv, P. P. Lopes, A. P. Paulikas, H. Li, S. X. Mao, C. Wang, N. M. Markovic, J. Li Orcid, V. R. Stamenkovic, and Y. Li. High-Performance Rh2P Electrocatalyst for Efficient Water Splitting, J Am Chem Soc 2017, 139, 5494):
(a) they shall absorb photons that are sufficiently high in energy for the photolysis of water to take place,
(b) they must be stable
(c) they must exhibit the maximum possible efficiency - the bandgap of the materials must be in the visible range. The optimum energy band gap should be 1.5 - 2 eV,
d) the surface should be resistant to corrosion in aqueous electrolyte solutions,
(e) the charge mobility in the photoelectrode volume should be high,
(f) the manufacturing method of the photoelectrode should ensure that it can be used on an industrial scale.

Silicon electrodes are commonly used in solar cells. However, the use of this material in PEC cells results in a very rapid drop in performance, due to corrosion of the silicon in contact with the electrolyte.

Also commonly used electrode material is platinum (Pt). Alternatively, a composite of ruthenium oxide (RuO₂)/iridium oxide (IrO₂) is proposed. These materials are suitable for electrocatalytic processes with low overpotentials. However, due to the high cost and scarcity of precious metals in the Earth's crust, their long-term use for large-scale production is limited. As a result, the acceleration of hydrogen technology requires the development of new effective bifunctional, i.e. leading to the general splitting of water, electrocatalysts produced based on base metals.

Recently, various base metal electrocatalysts, such as nickel, cobalt, iron, copper, manganese and titanium, have been found to be promising for use in hydrogen catalysis *(*Li R. et al. New TiO2-Based Oxide for Catalysing Alkaline Hydrogen Evolution Reaction with Noble Metal-Like Performance. Small Methods 2021, 5). Metal oxides appear to be particularly attractive due to their semiconducting properties, high chemical stability and abundant resources. One that has been intensively studied as a material for electrocatalysis as well as photocatalysis is TiO₂-titanium oxide (Li R. et al. New TiO2-Based Oxide for Catalyzing Alkaline Hydrogen Evolution Reaction with Noble Metal-Like Performance. Small Methods 2021, 5*;* Agegnehu, AK. et al. Visible light responsive noble metal-free nanocomposite of V-doped TiO2 nanorod with highly reduced graphene oxide for enhanced solar H2 production. In International Journal of Hydrogen Energy 20161 41: 6752-6762*;* Xiu Z. et al. Recent advances in Ti3+ self-doped nanostructured TiO2 visible light photocatalysts for environmental and energy applications. Chemical Engineering Journal 202; 382, https://doi.org/10.1016/j.cej.2019.123011*.* However, limitations to its use are due to the high overpotential in the oxygen evolution reaction on the photoanode.

An alternative is to synthesise TiO₂-based heterostructures. These composites provide greater charge dissipation and a faster surface reaction, which should provide a higher rate and efficiency (with a low overpotential close to the theoretical value) of total water splitting.

As indicated in the literature (Li R. et al. New TiO2-Based Oxide for Catalyzing Alkaline Hydrogen Evolution Reaction with Noble Metal-Like Performance. Small Methods 2021, 5*;* Xiu Z. et al. Recent advances in Ti3+ self-doped nanostructured TiO2 visible light photocatalysts for environmental and energy applications. Chemical Engineering Journal 202; 382, https://doi.org/10.1016/j.cej.2019.123011) the use of TiO₂-based heterostructures in combination with other metals and oxides has been studied. The result was an increase in surface adsorption and reaction kinetics rates. Such heterostructures result in the formation of gaps and other defects on interfacial surfaces. As a result, electrochemical active sites are created to facilitate charge dissipation and surface reactions, and metals and metal oxides in combination with TiO₂, act as catalysts.

In contrast, a paper by Dong et al. revealed that the NiTiO₃ semiconductor can be used as a catalyst and photocatalyst for hydrogen generation. However, the limitation is the high recombination rate, high overpotential and slow reaction kinetics (Dong C. et al. Hierarchical Ni/NiTiO3 derived from NiTi LDHs: A bifunctional electrocatalyst for overall water splitting. J Mater Chem A Mater 2017; 5, 24767-24774).

In recent years, eutectic heterostructures have been successfully applied in thermoelectric systems and solid oxide fuel cells (SOFCs). As reported in the literature (Liu Y. et al. Unified Catalyst for Efficient and Stable Hydrogen Production by Both the Electrolysis of Water and the Hydrolysis of Ammonia Borane. Adv Sustain Syst 2019, 3*;* Wysmulek K. et al. A SrTiO3- TiO2 eutectic composite as a stable photoanode material for photoelectrochemical hydrogen production. Appl Catal B 2017, 206, 538-546), TiO₂-based eutectic composites (SrTiO₃-TiO2, WO₃-TiO₂) can be efficient photoanodes in photoelectrochemical water splitting. It has been shown that they can be obtained in sufficiently large sizes.

Also, bismuth oxide eutectics in combination with other oxides have been investigated as potential catalysts for HER reactions. In their publication, the team of Song et al. showed that the semiconductor p-n interface of a heterostructure can significantly enhance the electrocatalytic properties as the local electron density increases in the junction region. Interfacial boundaries of eutectic heterostructured materials play a key role in the electrochemical charge transfer process (Song XZ, Zhu WY, Ni JC, Zhao YH, Zhand T, Tan Z, Liu LZ, Wang XF Boosting Hydrogen Evolution Electrocatalysis via Regulating the Electronic Structure in a Crystalline-Amorphous CoP/CeOx p-n Heterojunction, ACS Appl Mater Interfaces 2022, 14, 33151).

The aim of the invention is to provide efficient electrodes for photoelectrochemical (PEC) cells.

The essence of the invention is a eutectic for use as an active layer in an electrode for photoelectrochemical cells (PEC), characterised in that it is a eutectic composite based on oxides selected from the group of TiO₂, NiO, NiTiO₃, Bi₂O₃, Bi₂CuO₄, V₂O₃, Bi₁₂TiO₂₀, BiVO₄.

Preferably, the eutectic according to the invention is a two-phase eutectic composite material NiTO₃-TiO₂.

Preferably, the eutectic according to the invention is a Bi₂O₃/Bi₂CuO₄, eutectic structure, where Bi₂O₃ is the n-type matrix and the Bi₂CuO₄ phase is p-type.

Preferably, the Bi₂CuO₄ content in the eutectic is 2.43%.

Preferably, the eutectic is a BiVO₄/V₂O₅ eutectic structure, where BiVO₄ is an n-type matrix and the V₂O₅ phase is p-type.

Preferably, the eutectic is a Bi₁₂TiO₂₀/TiO₂ eutectic structure, where Bi₁₂TiO₂₀ is the matrix, both phases being n-type semiconductors.

Preferably, the electrode is a cathode.

A further embodiment of the invention is an electrode for photoelectrochemical cells (PEC) comprising at least an active layer and an electrical contact and optionally a contact layer sandwiched between the active layer and the electrical contact or current collector, characterised in that the active layer is a eutectic according to the invention.

Preferably, the electrode according to the invention comprises a conductive layer.

Preferably, the outer layer of the electrode according to the invention comprises an active layer which is covered by at least one conductive layer.

Preferably, the conductive layer is positioned between the active layer and the electrical contact.

Preferably, the conductive layer is protected externally by an electrolyte resistant coating, preferably made of epoxy resin.

### The invention provides the following advantages:

Eutectic composites have a number of advantages over non-eutectic materials, in particular it is possible to form a great variety of phase combinations with a wide range of structural structures. Another advantage of eutectic composites is that they have a large number of interfacial boundaries, and the number of boundaries can be controlled by the growth rate. By annealing the eutectic composite e.g. in a reducing atmosphere, defects such as oxygen vacancies can be generated. The presence of oxygen vacancies increases the surface adsorption of the catalyst and, at the same time, the defects increase charge transport, which in turn increases the kinetics of the catalytic reaction. Eutectic composites are materials with two or more band gaps, which can enable the absorption of electromagnetic radiation over a wider range. In addition, electrochemically stable eutectics can be produced.

The NiTiO₃-TiO₂ eutectic composite according to the invention is characterised by its high crystallinity and sharp interfacial boundaries which promote charge flow. The NiTiO₃-TiO₂ eutectic exhibits excellent photocatalytic properties at low anodic potential (~0.26 V).

The NiTiO₃-TiO₂ composite according to the invention is advantageously annealed in a reducing atmosphere, which increases its efficiency, resulting in the material exhibiting effective water splitting in an alkaline electrolyte, at potentials for hydrogen and oxygen decomposition of water of - 0.25 and 0.02 V, respectively. As a result of annealing, the TiO₂ content increases, and the number of interfaces and the amount of oxygen vacancies increases. The numerous interfaces, porous surface and abundance of oxygen vacancies promote charge transfer at the electrode-electrolyte interface and increase surface adsorption. Such a composite can be used for both general water splitting and photoelectrochemical hydrogen generation.

Preferably, the Bi₂O₃/Bi₂CuO₄ eutectic structure according to the invention, where Bi₂O₃ is an n-type matrix and the Bi₂CuO₄ phase is p-type, can be used as a photocathode material for the HER process.

The most preferable Bi₂CuO₄ content in the eutectic is 2.43%. In an alkaline environment, Bi₂CuO₄ plays a key role in improving the catalytic activity of the eutectic composite compared to pure Bi₂O₃. The eutectic shows excellent HER properties at very low overpotential. A very narrow metallic region is formed at the interface in the form of Cu and Bi precipitates and numerous oxygen vacancies are produced. These defects act as active centres capable of absorbing hydrogen. This allows rapid dissociation of water and polarisation at very low potentials. The structural advantage of the Bi₂O₃/Bi₂CuO₄ heterojunction lies in the very low overpotential which results in a high current density value of 50mA/cm². The charge transfer resistance in Bi₂O₃ decreases significantly due to the presence of the Bi₂O₃/Bi₂CuO₄ interfaces. The interfaces also favour the diffusion of electrolyte ions across the electrode surface, which in turn improves the hydrogen adsorption properties.

The Bi₂O₃/Bi₂CuO₄ eutectic also shows long-term stability of up to 1000 cycles, making it a promising candidate for electrochemical water splitting.

The BiVO₄/V₂O₅ eutectic forms a material in which both phases absorb visible light, where the band gap is 2.5 eV (~477 nm) for BiVO₄ and 2.3 eV (~540 nm) for V₂O₅. In addition, V₂O₅ improves the electrical conductivity of the eutectic, which facilitates electron transport.

The Bi₁₂TiO₂₀/TiO₂ eutectic exhibits good photocatalytic properties due to enhanced absorption of visible light and improved separation of photo-generated charges. The band gap of Bi₁₂TiO₂₀ allows the eutectic to absorb a wider range of light. The formed transitions between the Bi₁₂TiO₂₀ and TiO₂ phases help to reduce electron-hole recombination, leading to more efficient photocatalysis. Both materials are chemically stable, making the composite durable under operational conditions.

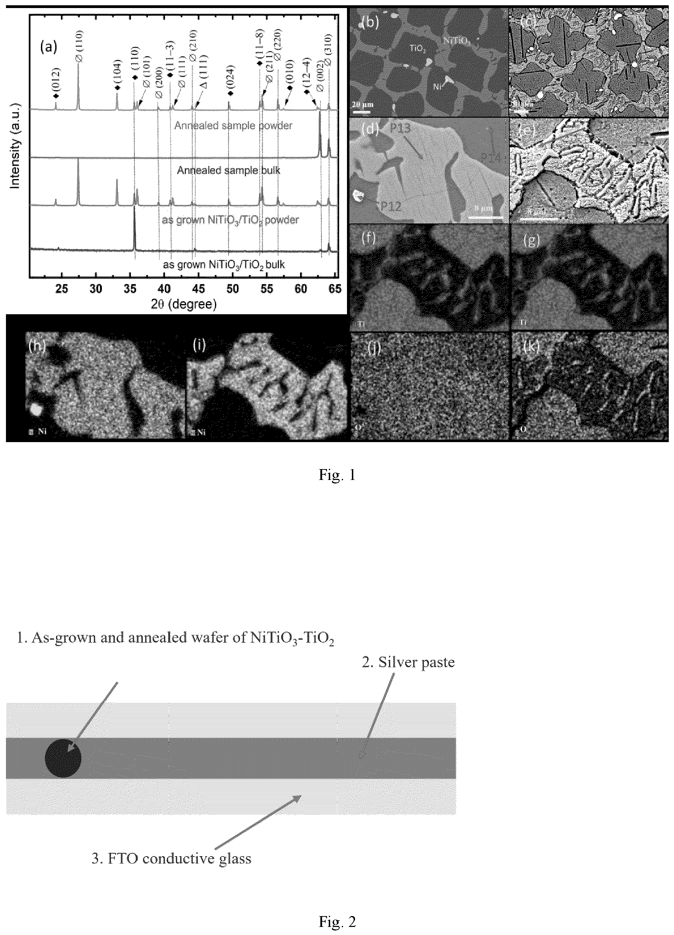

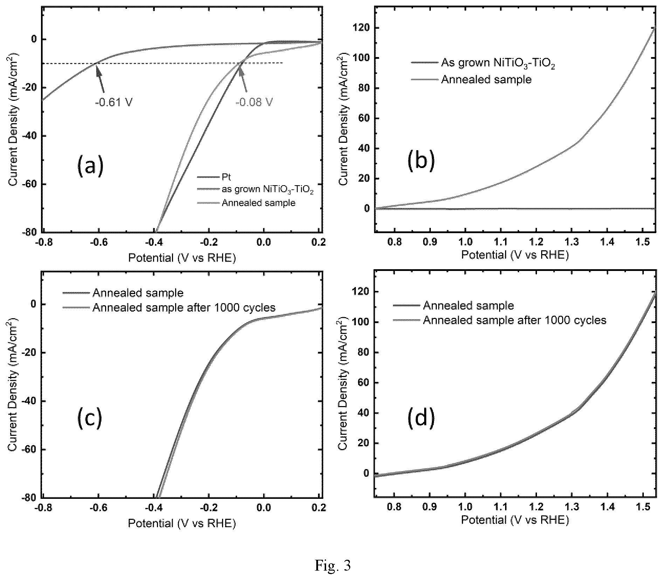

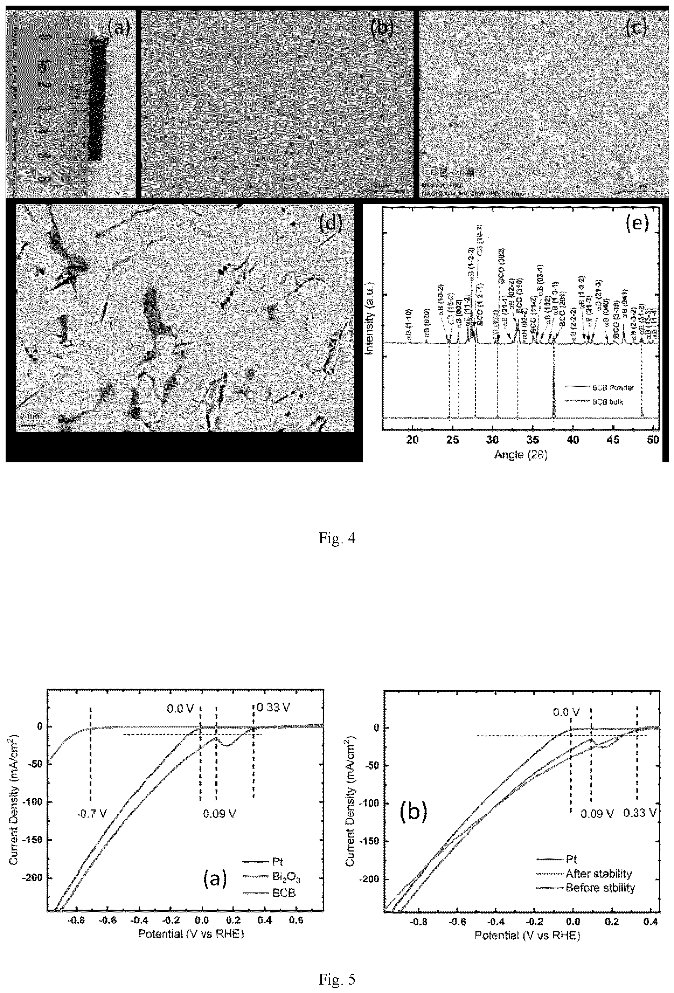

The invention is illustrated in the worked examples and in the drawing, where fig. 1 shows the morphology of a NiTiO₃-TiO₂ electrocatalyst cathode fabricated according to example 1, where (a) shows XRD diffractograms, (b) shows the SEM image of the cathode at low resolution, 20 µm pitch, (c) shows the SEM image of the cathode at high resolution, 20 µm scale, (d) shows the SEM image of the cathode at low resolution, 8 µm scale, (e) shows the SEM image of the cathode at high resolution, 8 µm scale, (f-k) show the elemental distribution maps in the as-grown composite (f, h, j) and after annealing ( g, i ), respectively: ( f, g) titanium, (h, i) nickel and (j, k) oxygen; fig. 2 shows a diagram of the electrode according to example 2; fig. 3 shows the results of current density measurements for the electrocatalyst anode (a) and cathode (b), and the measurement of the stability of the current density for the anode (c) and cathode (d) of the electrocatalyst produced according to example 1, i.e. NiTiO₃-TiO₂, using the electrolyte 1M KOH; fig. 4 shows the results of the structure and morphology of the electrocatalyst cathode fabricated according to Example 3, i.e. Bi₂O₃-Bi₂CuO₄, where (a) Bi₂O₃-Bi₂CuO₄ rod, (b) FE-SEM and (c) corresponding EDS map, (d) high-resolution FE-SEM image of BCB, (e) XRD diffractogram for volumetric and powdered crystal; fig. 5 shows the results of a current stability measurement for an electrocatalyst cathode made according to example 3, i.e. Bi₂O₃-Bi₂CuO₄, using 1M KOH electrolyte.

### Example 1.

### NiTiO₃-TiO₂ composite for use as an electrocatalyst electrode.

In this example, the eutectic material (nickel titanate-titanium oxide) was prepared by the micro-pulling-down (µ-PD) method in a nitrogen atmosphere. High-purity TiO₂ (99.995%) and NiO (99.999%) powders are used as starting materials. The materials are mixed in a super-eutectic ratio: 69% mol. TiO₂ and 31% mol. NiO. The mixture is ground with pure 2-propanol in an alumina mortar. The resulting slurry is then annealed at 90°C for 2 h to remove any volatile impurities, followed by annealing at 1100°C for 10 h. The resulting product is used to make NiTiO₃-TiO₂ rods in the above µ-PD device. The extraction rate used is approximately 3 mm /min. The resulting eutectic rods are cut into small pieces (small disc thickness ~600 µm) perpendicular to the growth direction and then polished to a thickness of ~200 µm. In the final step, the disks are annealed at 1140°C for 4 min in a hydrogen atmosphere.

Powder X-ray diffraction showed the presence of NiTiO₃ and TiO₂ (rutile) phases in the composite (fig. 1a), further demonstrating the presence of a small concentration of Ni metal. Both phases grow in the highlighted crystallographic orientation, mainly (110) for NiTiO₃ and (310) for TiO₂. The presence of NiTiO₃ and TiO₂ as well as Ni was also demonstrated by SEM studies (as shown in Fig. 1. b-k).

The effect of annealing the eutectic wafers is the disappearance of the NiTiO₃ phase, the NiTiO₃:TiO₂ weight ratio after annealing decreased from 1: 1.34 to 1:1.55. This indicates a change in the surface of the wafers as a result of annealing. The surface of the specimen becomes rough and partially porous, which is clearly visible in the high-magnification SEM images. Small microstructures of the NiTiO₃ phase are distributed in the TiO₂ matrix phase (arms of the square structure) (Fig. 1).

### Example 2.

### Electrodes containing the eutectic material NiTiO₃-TiO₂

The eutectic material, as in example 1 (as-grown and/or annealed nickel titanate-titanium oxide), bonded with silver paste 2 onto FTO conductive glass 3 (FTO). These constitute the faceplates 1 of the fabricated electrodes. The electrode thus prepared is annealed for 2 h at 100 °C. The electrode is then sealed with epoxy resin at the boundary between the eutectic material and the rear electrical contact 3, at the point where the conductive paste 2 is applied.

A schematic of the electrode is shown in fig.2. The electrode consists of a thin layer of eutectic material 1 with semiconductive properties, an ohmic contact of silver paste (or other conductive paste or medium providing ohmic contact) and a back electrical contact (electrical contact 3), which can be of conductive glass FTO, metal (e.g. copper) or other electrically conductive material (e.g. ITO indium-doped tin oxide, a dielectric wafer covered with a conductive layer, etc.).

Current density and stability measurements were carried out for the cathode and anode prepared in this way. The results of the measurements are shown in fig. 3. As in example 1, the eutectic material can be used both as-grown and after annealing. It can be used as both cathode (fig. 3a) and anode (fig. 3b) for electrochemical water splitting. The grown NiTiO₃-TiO₂ composite has a high overpotential (at a current density of 10 mA/cm²) of 610 mV. After annealing, the overpotential was only 80 mV at the same current density. Due to the larger external active surface area of the electrode made of the annealed composite, this favours hydrogen adsorption. As a result, only a small overpotential was needed to achieve water splitting. In the case of the as-grown sample, OER polarisation started after a high potential of 1.5V. However, the annealed sample additionally shows good OER catalytic performance at a high current density of 100 mA/cm² at an anodic potential of 1.49V. Stability studies of the annealed eutectic material, as in example 1, were performed for use as both anode (Fig. 3c) and cathode (Fig. 3d) in the water splitting process. LSV graphs taken before and after 1000 cycles, show a similar profile and do not show significant changes before and after the stability test.

### Example 3.

### Bi₂O₃/Bi₂CuO₄ eutectic material for use as an electrocatalyst electrode

In this embodiment, a eutectic material (Bi₂O₃/Bi₂CuO₄) was prepared by the micro-pulling-down (µ-PD) method in a nitrogen atmosphere. High-purity copper oxide (CuO) (Alfa Aesar) and bismuth oxide (Bi₂O₃) (Alfa Aesar) powders were used as raw materials. Initially, the oxides are ground in an alumina mortar with 2-propanol. The resulting mixture is then annealed at 350 °C for 2 hours to remove volatile impurities. The µ-PD process is carried out at a temperature above the eutectic temperature of 784 °C in a nitrogen atmosphere, with a crystal growth rate of approximately 2 mm/min.

The grown Bi₂O₃/Bi₂CuO₄ rod (5 mm diameter) is cut into wafers about 600 µm thick. The Bi₂O₃/Bi₂CuO₄ discs are then polished to a thickness of ~200 µm. These discs of low thickness are designated BCB. The measured structure and morphology of the eutectic 2 as-grown and annealed material is shown in Fig. 4.

Fig. 4a shows the Bi₂O₃/Bi₂CuO₄ rod. In contrast, Fig. 4b and 4c show the SEM image of Bi₂O₃/Bi₂CuO₄ and the corresponding EDS mapping. The EDS maps show that Bi₂O₃ is the matrix of the eutectic composite, as Bi (red) and O (blue) are evenly distributed. There are also Cu-rich areas (green) in the matrix, suggesting that Bi₂CuO₄ has formed a eutectic system in Bi₂O₃. In the backscattered FE-SEM image (Fig. 4d), the interfaces are clearly visible, with dark and light areas corresponding to Bi₂CuO₄ and Bi₂O₃, respectively (Fig. 4e). XRD analysis (Fig.4e) showed the presence of three different crystal structures corresponding to (i) single-stranded Bi₂O₃ (αB), (ii) cubic Bi₂O₃ (cB) and (iii) tetragonal Bi₂CuO₄ (BCB). The bulk sample was cut from the rod in the vertical direction and polished to obtain a well-directed plane. XRD results suggest that the BCB crystal has a dominant plane (310) of Bi₂CuO₄ in the Bi₂O₃ matrix. Quantitative analysis, based on XRD peaks, indicates that the weight % of monoclinic Bi₂O₃, (ii) cubic Bi₂O₃ and (iii) tetragonal Bi₂CuO₄, are 85.5, 12.1 and 2.43%, respectively. XRD and FE-SEM analyses showed that despite the small amount of tetragonal Bi₂CuO₄, it forms huge interfaces on the surface.

### Example 4.

### Electrodes containing the eutectic material Bi₂O₃/Bi₂CuO₄

The eutectic material, as in example 3, is pasted with silver paste 2 (commercially available) onto conductive glass 3 (FTO). These then form the faceplates 1 in the fabricated electrodes. The electrode thus prepared is annealed for 2 h at 100 °C. The prepared electrode is protected with epoxy resin at the boundary between the eutectic material 1 and the back electrical contact 3, at the point of application of the conductive paste 2. Measurements of the current density and its stability were performed for the cathode prepared in this way. The results of the measurements are shown in Fig. 5. Linear voltammetry (LSV) of Pt was used as a reference to compare HER performance (Fig. 5a). For pure Bi₂O₃, polarisation started at ~-0.7 V and a current response of 10 mA/cm² was achieved at an overpotential of ~-0.8 V. Surprisingly, the Bi₂O₃/Bi₂CuO₄ electrode showed a lower initial potential than Pt. For Pt the polarisation started at ~0 V, but for BCB the initial polarisation was observed at a positive potential of ~0.09 V. Furthermore, BCB shows a high current density of 50 mA/cm² corresponding to a very small overpotential of ~-0.13 V. Fig. 5b shows the LSV plot of Bi₂O₃/Bi₂CuO₄, and after 1000 cycles. Compared to the initial cycle, the LSV kinetics became slow after stabilisation. To achieve a current density of 100 mV/cm², it was necessary to exceed the potential by -0.4 V both before and after the stability test.

### Example 5.

### BiVO₄lV₂O₅ eutectic material for use as an electrocatalyst electrode

In this example, the eutectic material (BiVO₄/V₂O₃) was prepared by the micro-pulling-down (µ-PD) method in a nitrogen atmosphere. The raw materials used were high-purity bismuth oxide (Bi₂O₃) (Alfa Aesar) and vanadium oxide (V₂O₃) (Alfa Aesar) powders. The materials were mixed in the eutectic ratio: 90 mol% V₂O₅ and 10 mol% Bi₂O₃. The oxides were initially ground in an alumina mortar with 2-propanol. The resulting mixture was then heated at 350 °C for 2 hours to remove volatile impurities. The µ-PD process was carried out at a temperature above the eutectic temperature of 620 °C in a nitrogen atmosphere, at a crystal growth rate of approx. 2 mm/min. The grown BiVO₄/V₂O₅ rod is cut into approximately 500 µm thick wafers. Then the BiVO₄/V₂O₅ disks are polished to a thickness of ~200 µm.

### Example 6.

### Electrodes containing eutectic material BiVO₄lV₂O₅

The eutectic material, similarly to examples 2 and 4, is glued using silver paste 2 (available on the market) onto conductive glass 3 (FTO). They then constitute front plates 1 in the produced electrodes. The electrode prepared in this way is annealed for 2 hours at a temperature of 100 °C. The prepared electrode is protected with epoxy resin at the boundary of the eutectic material 1 and the rear electrical contact 3, at the place where the conductive paste 2 is applied.

### Example 7.

### Eutectic material Bi₁₂TiO_{2/}TiO₂ for use as an electrocatalyst electrode

In this embodiment, the eutectic material (Bi₁₂TiO₂₀/TiO₂) was prepared by the micro-pulling-down (µ-PD) method in a nitrogen atmosphere. High-purity titanium oxide (TiO₂) (Alfa Aesar) and bismuth oxide (Bi₂O₃) (Alfa Aesar) powders were used as raw materials. The materials were mixed in the eutectic ratio: 0.81 mol% TiO₂ and 99.19 mol% Bi₂O₃. The oxides were initially ground in an alumina mortar with 2-propanol. The resulting mixture was then heated at 350 °C for 2 hours to remove volatile impurities. The µ-PD process is carried out at a temperature above the eutectic temperature of 823 °C in a nitrogen atmosphere, at a crystal growth rate of about 2 mm/min.

### Example 8.

### Electrodes containing eutectic material Bi₁₂TiO₂₀/TiO₂

The eutectic material, similarly to examples 2, 4, 6, is glued using silver paste 2 (commercially available) to conductive glass 3 (FTO). They then constitute front plates 1 in the produced electrodes. The electrode prepared in this way is annealed for 2 hours at a temperature of 100 °C. The prepared electrode is protected with epoxy resin at the boundary of the eutectic material 1 and the rear electrical contact 3, at the place where the conductive paste 2 is applied.

## Claims

1. An eutectic for use as an active layer in an electrode for photoelectrochemical cells (PEC), **characterised in that** it is a eutectic composite based on oxides selected from the group of TiO2, NiO, NiTiO3, Bi203, Bi2Cu04, V₂O₃, Bi₁₂TiO₂₀, BiVO₄.

2. The eutectic for use according to claim 1, **characterised in that** it is a biphasic eutectic composite material of NiTO₃-TiO₂.

3. The eutectic for use according to claim 1, **characterised in that** it is a Bi₂O₃/Bi₂CuO₄ eutectic structure, where Bi₂O₃ is an n-type matrix and the Bi₂CuO₄ phase is p-type.

4. The eutectic for use according to claims 1 or 3, **characterised in that** the Bi₂CuO₄ content in the eutectic is 2.43%.

5. The eutectic for use according to claim 1, **characterised in that** it is a BiVO₄/V₂O₅ eutectic structure, where BiVO₄ is an n-type matrix and the V₂O₅ phase is p-type.

6. The eutectic for use according to claim 1, **characterised in that** it is a Bi₁₂TiO₂₀/TiO₂ eutectic structure where Bi12TiO₂₀ is the matrix, both phases being n-type semiconductors.

7. The eutectic for use according to any of the preceding claims 1 to 4, **characterised in that** the electrode is a cathode.

8. A photoelectrochemical cell (PEC) electrode comprising at least an active layer and an electrical contact, and optionally a contact layer sandwiched between the active layer and the electrical contact or current collector, **characterised in that** the active layer is an eutectic as defined in any of the preceding claims 1 to 5.

9. The electrode according to claim 6, **characterised in that** it comprises a conductive layer.

10. The electrode according to claim 6 or 7, **characterised in that** its outer layer comprises an active layer which is covered by at least one conductive layer.

11. The electrode according to any of the preceding claims 6 to 8, **characterised in that** the conductive layer is positioned between the active layer and the electrical contact.

12. The electrode according to any of the preceding claims 7 to 9, **characterised in that** the conductive layer is protected externally by an electrolyte resistant coating, preferably made of epoxy resin.
